# EUROPEAN PATENT SPECIFICATION

(11) **EP 3 007 238 B1**
(45) Date of publication and mention of the grant of the patent: **01.04.2020**
(21) Application number: 14803813.6
(22) Date of filing: 14.05.2014
(51) Int. Cl.: H01L 25/075, H01L 33/38, H01L 33/40, H01L 23/00, H01L 27/15

(54) **SEMICONDUCTOR LIGHT-EMITTING ELEMENT AND SEMICONDUCTOR LIGHT-EMITTING DEVICE**
LICHTEMITTIERENDES HALBLEITERBAUELEMENT UND LICHTEMITTIERENDE HALBLEITERVORRICHTUNG
ÉLÉMENT ÉLECTROLUMINESCENT SEMI-CONDUCTEUR ET DISPOSITIF ÉLECTROLUMINESCENT SEMI-CONDUCTEUR

(30) Priority: 30.05.2013 JP 2013113916
(43) Date of publication of application: 13.04.2016
(73) Proprietor: Stanley Electric Co., Ltd., Meguro-ku Tokyo 153-8636 (JP)
(72) Inventor: MIYACHI, Mamoru, Tokyo 153-8636 (JP); SAITO, Tatsuma, Tokyo 153-8636 (JP)
(74) Representative: Klang, Alexander H.
(86) International application number: PCT/JP2014/002538
(87) International publication number: WO 2014/192237

(56) References cited:
- EP-A2- 2 405 491
- JP-A- 2012 019 217
- JP-A- 2012 124 538
- US-A1- 2009 101 923

## Description

### FIELD OF THE INVENTION

The present invention relates to a semiconductor light-emitting device. A term "GaN containing semiconductor" refers to a group III-V compound semiconductor containing Ga as a group III element and N as a group V element. An example is AlₓGa_{y}In_{z}N (0 ≤ x < 1, 0 < y ≤ 1, 0 ≤ z < 1, and x + y + z = 1).

### BACKGROUND ART

For a semiconductor light emitting element in which an n-type semiconductor layer, an active layer, and a p-type semiconductor layer are laminated, an n-side electrode and a p-side electrode electrically connected to the n-type semiconductor layer and the p-type semiconductor layer are necessary. For example, a transparent electrode is formed on the entire surface of the p-type semiconductor layer, a p-side electrode is formed on part of the transparent electrode and is covered with an insulating layer. When via holes which penetrates the p-type and the active layers, reaching the n-type semiconductor layer, are formed and n-side via electrodes are formed on the n-type semiconductor layer exposed at the via holes, the n-side and the p-side electrodes can be disposed on the same surface on the p-type semiconductor layer side.

For example, it has been proposed to specify the diameter of a first conductivity type layer exposed at the via hole to be 10 to 30 µm, to specify the via electrode center-to-center distance (pitch) to be 75 to 125 µm, and to specify the total contact area of the via electrode to be 5% or less, particularly 2% or less, of the semiconductor area (for example, JP 2011-066304 A and JP 2011-517064 A).

US 2009/101 923 A discloses a semiconductor light emitting device which has a first conductivity type semiconductor layer, an active layer, a second conductivity type semiconductor layer, a second electrode layer, and insulating layer, a first electrode layer, and a conductive substrate sequentially laminated. The second electrode layer has an exposed area at the interface between the second electrode layer and the second conductivity type semiconductor layer. The first electrode layer includes at least one contact hole electrically connected to the first conductivity type semiconductor layer, electrically insulated from the second conductivity type semiconductor layer and the active layer, and extending from one surface of the first electrode layer to at least part of the first conductivity type semiconductor layer.

EP 2 405 491 A2 also discloses a semiconductor light-emitting device.

### SUMMARY OF THE INVENTION

A vehicle headlight injecting lights output from a semiconductor light-emitting device directly to a lens and irradiate the lights on object region has been developed. In such use, characteristics of, for example, a high power conversion efficiency of 100 Im/W at a high driving power of 10 W or more, uniform brightness distribution, and uniform color distribution are desired.

It is an object of the present invention to provide a semiconductor light-emitting device which is suitable for application to vehicle headlights and the like and which exhibits a high power conversion efficiency, uniform brightness distribution, and uniform color distribution.

According to the present invention, a semiconductor light-emitting element is provided as set forth in claim 1, and a semiconductor light-emitting device is provided as set forth in claim 14.

Preferred embodiments of the present invention may be gathered from the dependent claims.

A high power conversion efficiency can be obtained at a high driving power. The in-plane brightness distribution and the color distribution can be suppressed.

### BRIEF DESCRIPTION OF THE DRAWINGS

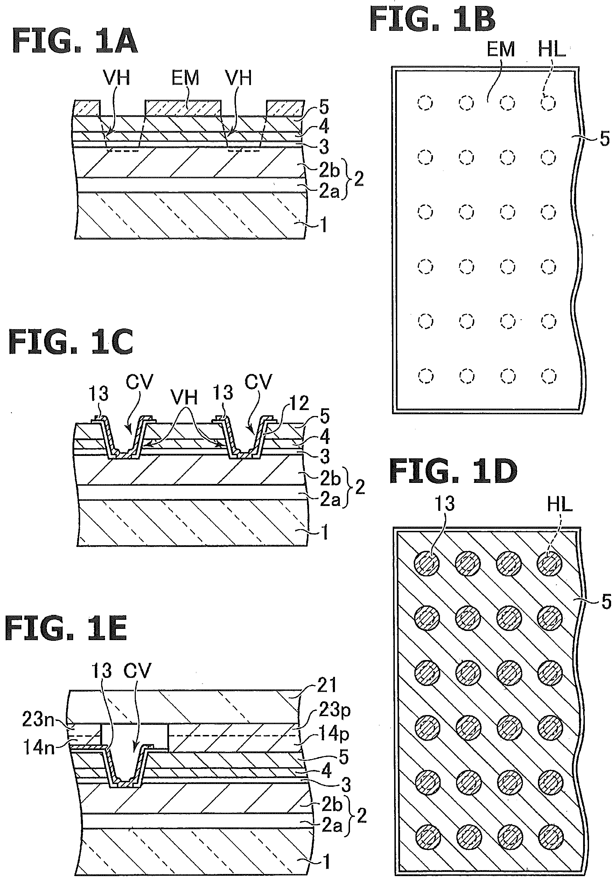

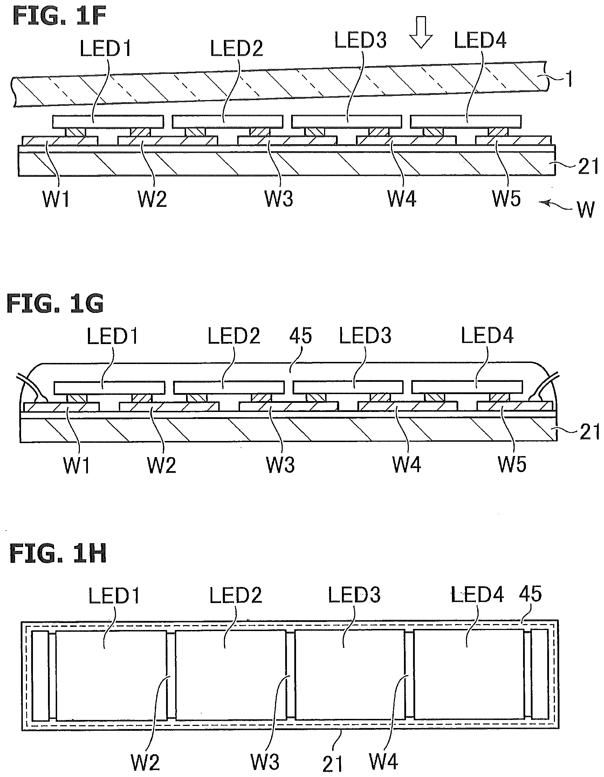

Figs. 1A and 1B are a schematic sectional view and a schematic plan view, showing an embodiment in a state in which a second semiconductor layer side electrode is formed on a semiconductor laminate containing a first semiconductor layer, an active layer, and a second semiconductor layer, and a patterning mask is formed thereon. Fig. 1C and Fig. 1D are a schematic sectional view and a schematic plan view, showing a state in which via holes penetrating the second semiconductor layer and the active layer are formed and first semiconductor layer side electrodes electrically connected to the first semiconductor layer are formed. Fig. 1E is a schematic sectional view showing a state in which a support substrate is coupled and Fig. 1F is a schematic sectional view showing a state in which a growth substrate is removed after the support substrate is coupled. Fig. 1G is a schematic sectional view showing a state in which a resin layer containing a fluorescent powder is formed on an emitting surface containing a series of LED elements, and Fig. 1H is a schematic plan view of a state corresponding to the state shown in Fig. 1G.
Fig. 2A to Fig. 2L are schematic sectional views showing the production steps of a semiconductor light-emitting device according to the embodiment.
Fig. 3 is a schematic sectional view in the vicinity of an n-side electrode 13.
Fig. 4A is a schematic plan view showing changes in the pitch of the n-side electrodes by using via holes, and Fig. 4B is a graph of calculation values and measurement values showing changes in the power conversion efficiency versus changes in the via pitch.
Fig. 5A is a graph showing changes in the power conversion efficiency versus changes in the contact area size of the n-side electrodes, determined on the basis of simulation, and Fig. 5B is a graph showing changes in the power conversion efficiency versus changes in the ratio of the contact area of the n-side electrodes to the area of the semiconductor layer, determined on the basis of simulation.
Fig. 6A and Fig. 6B are schematic sectional views showing vehicle illumination apparatuses according to application examples.

### DESCRIPTION OF THE PREFERRED EMBODIMENTS

A semiconductor light-emitting device is usually formed by stacking epitaxially grown layers on a growth substrate. For example, a GaN containing semiconductor laminate in which an n-type GaN containing semiconductor layer, a GaN containing light-emitting layer, and a p-type GaN containing semiconductor layer are stacked is formed on a sapphire substrate. The sapphire substrate is an insulating layer and therefore cannot be used as part of an electrode. A p-side electrode and an n-side electrode are formed on the GaN containing semiconductor laminate. The emitted lights are usually taken from the sapphire substrate side.

The thermal conductivity of sapphire is not high. It can be said that the sapphire substrate does not have a positive function other than a physically supporting function after playing roll as the growth substrate. A configuration in which a silicon substrate or the like having high thermal conductivity is bonded on a p-type GaN containing semiconductor layer, the sapphire substrate having served as the growth substrate is removed, and the output lights are emitted from the n-type GaN containing semiconductor side has been developed. The sapphire substrate is removed, so that heat irradiation characteristics can be improved, the n-type GaN containing semiconductor layer surface can be subjected to micro cone process or the like, and a semiconductor light-emitting device having better characteristics can be formed. The case where the growth substrate is removed to expose the n-type semiconductor layer will be described below.

A semiconductor light-emitting element capable of generating high output lights having uniform brightness distribution and uniform color distribution is desired for a vehicle headlamp. A semiconductor light-emitting element in which the growth substrate is removed and the exposed n-type GaN containing semiconductor layer serves as a light-emitting surface is promising. The light output can be increased by widely forming a reflective electrode on the p-type GaN containing semiconductor layer surface on the back surface side. In addition, as for the n-side electrode, a configuration, in which via holes penetrating through the p-type GaN containing semiconductor layer and the light-emitting layer, exposing the n-type GaN containing semiconductor layer is formed and the n-side electrodes in contact with the n-type GaN containing semiconductor layer at the bottom of the via holes are formed and are lead on the rear surface side, has possibility of giving characteristics suitable for this use.

When a driving current passes the semiconductor laminate, and the light-emitting layer is allowed to emit lights, the lights propagate in every direction. In case when the output lights are taken from the n-type GaN containing semiconductor layer side, in order to effectively take out the lights propagating from the light-emitting layer to the p-type semiconductor layer side, it is desirable to dispose a light reflector on the outer surface of the p-type GaN containing semiconductor layer. In order to increase the driving current and obtain large output light, it is desirable to form a reflective electrode with high reflectance which is in ohmic contact with the p-type semiconductor layer with as low resistance as wide as possible.

As for high-reflectance metal electrode formed on the p-type GaN containing semiconductor layer surface, Ag, Pt, Ni, Al, Pd, and alloys thereof have been known. It has been known that ohmic properties of the p-type GaN containing semiconductor layer can be enhanced by adding Ni, Pt, Ti, Pd, and the like. It has also been known that a p-side electrode, in which an indium tin oxide (ITO) layer is formed as an underlying layer and a layer of Ag or a Ag alloy is stacked thereon, can constitute a high performance p-side reflective electrode.

Silver has high reflectance but has a property to diffuse (migrate) easily. Diffused Ag causes unfavorable phenomena, for example, generation of leakage current. It is desirable that diffusion preventing structure for preventing diffusion of Ag is provided on the layer of Ag or Ag alloy.

It is desirable that the electrode for the n-type GaN containing semiconductor layer does not block the generated lights and can supply electrons to each point of the n-type GaN containing semiconductor layer with as low resistance as possible. If wiring which serves also as electrode is formed on the n-type GaN containing semiconductor layer, it will take a shape of stripe or the like, and then it becomes difficult to avoid reduction in the light-emitting area.

It is possible to form n-side wiring above the outer surface of the p-type GaN containing semiconductor layer, form via holes penetrating through the p-type GaN containing semiconductor layer and the light-emitting layer to expose the n-type GaN containing semiconductor layer, and form electrodes in the via holes connecting the n-type GaN containing semiconductor layer and the n-side wiring. The entire surface of the n-type GaN containing semiconductor layer can be exposed. The n-side electrodes formed in the via holes form contact regions distributed in the plane of the semiconductor layer. The effective area occupied by the n-side electrodes in the light-emitting region can be reduced.

The present inventors are conducting research and development for the technology wherein via holes are formed from the surface of the p-type semiconductor layer of the grown semiconductor laminate, penetrating the p-type semiconductor layer and the light-emitting layer to expose the n-type semiconductor layer, a p-side reflective electrode is formed on almost entire area of the p-type semiconductor layer excluding vicinities of the via holes, and n-side electrodes are formed in contact with the n-type semiconductor layer exposed in the via holes, connecting the n-side electrodes with wiring layer above the p-type semiconductor layer. The p-side reflective electrode is in contact with the p-type semiconductor layer surface in a large area excluding regions for forming the n-side electrodes, to reduce the contact resistance and improve the light derivation efficiency. No electrode is formed on the n-type semiconductor layer surface serving as an output light emitting surface.

The n-side electrodes are derived from the p-type semiconductor layer side. Such n-side electrodes, when viewed from above the n-type semiconductor layer, can be made small. However, the resistance component of the semiconductor layer increases in accordance with the distance from the n-side electrode and the brightness distribution in accordance with the reciprocal of the resistance component may be generated.

Wiring layers for the p-side electrode and the n-side electrodes can be disposed above the p-type semiconductor layer. Various patterns, e.g. stripe-shaped parallel electrodes, or totally stacked and mutually insulated electrodes in which holes are formed in an electrode nearer to the semiconductor layer, can be employed.

A GaN containing semiconductor light-emitting device according to an embodiment will be described below.

As shown in a sectional view of Fig. 1A, a semiconductor laminate is epitaxially grown on a growth substrate 1 of sapphire or the like. For example, a semiconductor laminate containing a GaN containing semiconductor buffer layer 2a, an n-type GaN containing semiconductor layer 2b, a multiple quantum-well active layer 3, and a p-type GaN containing semiconductor layer 4 is grown on the sapphire substrate 1. The n-type GaN containing semiconductor layer can be made without doping any n-type impurity.

For example, the n-type GaN layer 2b having a film thickness of about 5 µm is formed by doping Si or the like serving as an n-type impurity. The buffer layer 2a is not necessarily doped with the n-type impurity. The buffer layer 2a and the n-type GaN layer 2b may be collectively referred to as an n-type GaN layer 2. The multiple quantum-well active layer 3 includes, for example, alternately stacked InGaN well layers and GaN barrier layers. The p-type GaN containing semiconductor layer 4 is formed from, for example, a p-type GaN layer having a film thickness of about 0.5 µm doped with Mg or the like serving as a p-type impurity.

A p-side reflective electrode layer 5 containing Ag as a primary component is formed on the p-type GaN containing semiconductor layer 4. Silver exhibits high reflectance with respect to the visible light. Migration (diffusion) of Ag atoms causes leakage and the like. In order to ensure the ohmic properties and suppress migration of Ag, Ti or the like is added to Ag. A transparent electrically conductive layer, e.g. thin Ti layer or indium tin oxide (ITO) layer, may be formed between the Ag layer and the p-type GaN containing semiconductor layer. In order to perform via hole etching, an etching mask EM, e.g. a patterned silicon oxide film, is formed on the p-side reflective electrode layer 5.

Fig. 1B is a plan view of the p-side reflective electrode layer 5. The etching mask EM having openings HL arranged in the square matrix is formed on the p-side reflective electrode layer 5. The openings of the etching mask are indicated by broken lines. As shown in Fig. 1A, for example, dry etching by Cl based gas is performed in the opening portions of the etching mask, so that the p-side reflective electrode layer 5, the p-type GaN containing semiconductor layer 4, and the multiple quantum-well active layer 3 are etched to form via holes VH exposing the n-type GaN containing semiconductor layer 2b.

As shown in Fig. 1C, insulating layers 12 covering the side surfaces of the via holes VH and peripheral portions of the p-side reflective electrode 5 and exposing the n-type GaN containing semiconductor layer 2 at the bottoms of the via holes VH are formed from silicon oxide or the like. The n-side reflective electrodes 13 in ohmic contact with the n-type GaN containing semiconductor layer 2 exposed at bottoms of via holes VH are formed. For example, the n-side reflective electrodes 13 containing a Ti/Ag laminate are formed. The peripheral portions of the n-side reflective electrodes 13 overlap the peripheral portions of the p-side reflective electrode 5 without gaps when viewed from above the growth substrate 1. The n-side reflective electrodes 13 define cavity portions CV having a concave shape in conformity with the inner surface of the via hole VH.

Fig. 1D is a plan view of a state corresponding to the state shown in Fig. 1C. The openings (a plurality of via holes) indicated by broken lines of the p-side reflective electrode 5 are arranged in the square matrix and n-side reflective electrodes 13 are arranged covering these via holes and overlapping the surrounding p-side reflective electrode 5.

As shown in Fig. 1E, electrically conductive bonding layers 14n and 14p are formed on the electrodes of each LED element. A support substrate 21 provided with wirings 23n and 23p is aligned above the electrically conductive bonding layers 14n and 14p, and the wirings 23n and 23p are bonded to the electrically conductive bonding layers 14n and 14p to couple the support substrate. The cavity portions CV are surrounded by the semiconductor substrate and the support substrate.

For the sake of convenience, one bonding layer for each of the p-side electrode and the n-side electrode of each LED element is shown in the drawing. Etching of streets to divide the semiconductor laminate on the growth substrate into the individual LED elements is performed. For example, in case where four-aligned semiconductor light-emitting device in which four LED elements are connected in series is formed, a pattern in which four LED elements are aligned in one direction is formed.

As shown in Fig. 1F, after the support substrate 21 is bonded, the growth substrate 1 is removed by laser lift-off (LLO) or the like. For example, wirings W (W1 to W5), the number of which is larger than the number of the LED elements by one, are formed on the support substrate 21, e.g. a Si substrate, provided with an insulating film, e.g. an oxide film. The wirings W are bonded to the p-side reflective electrode 5 and the n-side reflective electrodes 13 with intervening bonding layers to couple the support substrate 21. Four LED elements LED1 to LED4 are connected in series between the wiring W1 and the wiring W5 at both ends. The wiring layers W having light reflective layer at the uppermost layer is disposed in the region between adjacent LED elements. Thereafter, the growth substrate 1 is removed by, for example, laser lift-off (LLO) through the use of an excimer laser. The surface of the n-type GaN containing semiconductor layer 2 is subjected to micro cone processing with an alkaline solution or the like, according to necessity, so that micro cone structure or the like is formed.

As shown in Fig. 1G, wire bonding or the like is performed. A resin layer 45 containing fluorescent particles is applied covering the four LED elements, and thereby, the light emitting surface is sealed. For example, in case of a blue-emitting LED element, yellow fluorescent particles are mixed in the seal resin, to generate white lights.

Fig. 1H is a plan view of the configuration illustrated in Fig. 1G. The wirings W2, W3, and W4 having the light reflective layer at the uppermost layer are disposed in the region between the LED elements. A plurality of via holes are formed in the stacked semiconductor layer, and reflective electrodes 13 are disposed in the regions including the via holes. The regions between the LED elements and the regions of the via holes in the LED elements do not include the light-emitting layer 3, and therefore, do not have a light emitting function. However, a light reflecting function is provided because of the wiring and the electrodes having light reflecting function. The resin layer 45 containing fluorescent particles exists covering the semiconductor structure. When the blue lights emitted from the entire light-emitting layer 3 are absorbed by the fluorescent particles, yellow lights are emitted as fluorescence. The light reflective wiring W between the LED elements, the p-side reflective electrode 5 extended over almost entire region of the p-type semiconductor layer, and the n-side reflective electrodes 13 covering the distributed via regions reflect the fluorescence. Local brightness reduction is suppressed by the reflected light.

The brightness distribution depending on the distance from the n-side electrode (change in resistance) can be suppressed by increasing the distribution density of the n-side electrodes and decreasing the maximum distance from each point of the semiconductor layer to an n-side electrode. Reduction in the light-emitting area due to formation of the n-side electrodes can be suppressed by limiting the proportion of the total area of the n-side electrodes relative to the semiconductor layer area. If the current density per unit area is too large, the current conversion efficiency is reduced. Reduction in the current conversion efficiency can be suppressed by controlling the current density.

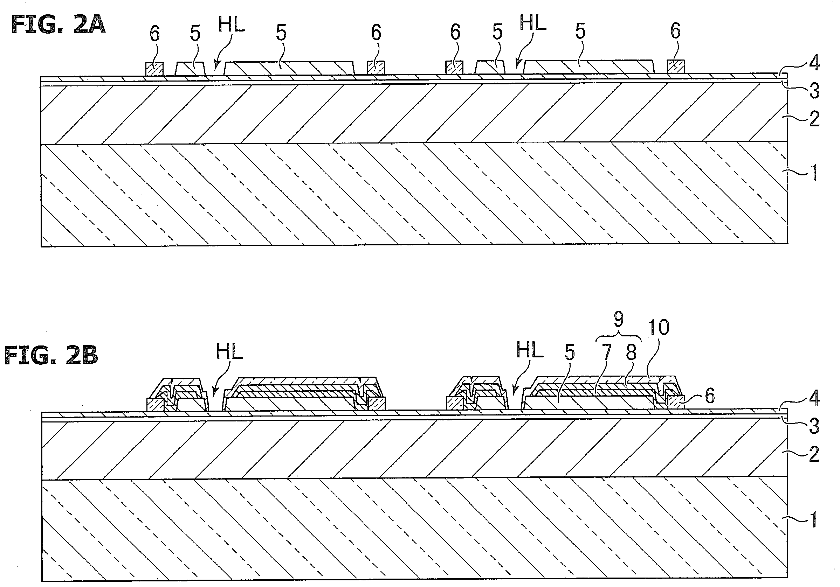

Fig. 2A to Fig. 2L are schematic sectional views showing the production steps of a semiconductor light-emitting device according to the embodiment. For the purpose of simplifying the drawing, two LED elements are shown as examples, and one n-side electrode per LED element is shown as an example.

As shown in Fig. 2A, for example, a sapphire substrate serving as a growth substrate 1 is put into a MOCVD device and thermal cleaning is performed. After a GaN buffer layer and an undoped GaN layer are grown, an n-type GaN layer which is doped with Si or the like and which has a thickness of about 5 µm is grown. The GaN buffer layer, the undoped GaN layer, and the n-type GaN layer may be collectively referred to as an n-type GaN layer 2.

A light-emitting layer (active layer) 3 is grown on the n-type GaN layer 2. As for the light-emitting layer 3, for example, such a multiple quantum-well structure may be used in which the well layer is formed of an InGaN layer and the barrier layer is formed of a GaN layer. A p-type GaN layer 4 which is doped with Mg or the like and which has a film thickness of about 0.5 µm is grown on the light-emitting layer 3.

The growth substrate 1 is selected from a single crystal substrate which has a lattice constant capable of epitaxially growing GaN and which is transparent at the wavelength of 362 nm that is an absorption edge wavelength of GaN in order to enable substrate removal by laser lift-off possible. Besides sapphire, spinel, SiC, ZnO, and the like may be used.

A p-side electrode layer 5 having light reflectivity is formed on the p-type GaN layer 4. In order that the p-side electrode layer 5 functions as a reflective electrode, Ag, Pt, Ni, Al, Pd, or an alloy thereof is used preferably. When the light which is emitted from the light-emitting layer 3 and which moves upward reaches the lower surface of the p-side electrode layer 5, the light is reflected downward. For example, a layer, which has a thickness of 200 nm and in which additives, such as, Ni, Pt, Ti, and Pd, are added to Ag, is deposited by electron beam evaporation and patterning is performed by lift-off. Penetrating openings HL are formed in the p-side electrode layer 5 at the locations to be provided with n-side electrodes. Specifically, as shown in Fig. 1D, a plurality of openings HL are disposed substantially in square matrix configuration, for example.

In accordance with the necessity of wiring formation or the like, part of the arrangement of the openings, for example, arrangement of one line at the end portion, may be changed slightly. In this case, most of the openings, for example, 80% or more or 90% or more, form the square matrix. In this case, it can be said that the "main portion" of the openings form square matrix. For the purpose of simplifying the drawing, only one opening is shown in the drawings of Fig. 2A to Fig. 2L.

In practice, the p-side electrode layer 5 is a layer extended over almost entire surface of the p-type semiconductor layer of one LED element. In the plane thereof, a plurality of openings HL are formed, as shown in Figs. 1B and 1D, and an n-side electrode 13 is disposed in such a way as to cover each opening region, as shown in Fig. 1D.

A fringe layer 6 of an insulator is formed in such a way as to surround the p-side electrode 5. For example, a SiO₂ layer having a film thickness equal to the thickness of the p-side electrode 5 is deposited by sputtering on the p-type GaN layer 4 outside the p-side electrode 5, and patterning is performed.

As shown in Fig. 2B, a p-side highly reflective cap layer 9 is formed by stacking a p-side highly reflective layer 7 and a p-side diffusion prevention layer 8. For example, a Ag layer having a film thickness 100 nm and serving as the highly reflective layer 7 and a TiW/Ti/Pt/Au/Ti layer (in the expression of the stacked structure, a layer formed on the substrate side or the lower side is shown on the left, similar meaning hereinafter) having a film thickness of 250 nm/50 nm/100 nm/1,000 nm/30 nm and serving as the diffusion prevention layer 8 are deposited on the upper surfaces of the p-side electrode 5 and the fringe layer 6, and on the p-type GaN layer 4 between the p-side electrode 5 and the fringe layer 6, for example, by sputtering, and then patterned by lift-off. The outer edge of the highly reflective layer 7 is disposed on the p-side electrode 5 or the fringe layer 6.

The p-side electrode 5 contains additives, such as, Ni, Pt, Ti, and Pd, to obtain ohmic contact with the p-type GaN layer 4. On the other hand, no additive is added to the p-side highly reflective layer 7. The p-side highly reflective layer 7 is in contact with the p-type GaN layer 4 in the region surrounded by the p-side electrode 5 and the fringe layer 6. Therefore, diffusion of Ag from the p-side highly reflective layer 7 is suppressed.

The p-side diffusion prevention layer 8 is a layer for preventing diffusion of the material used in the p-side electrode 5 upward, and Ti, W, Pt, Pd, Mo, Ru, Ir, Au, and alloys thereof can be used in case when the p-side electrode 5 contains Ag.

For example, the p-side highly reflective cap layer 9 is not formed in the vicinity of the edge of the opening HL, and the edge of the p-side highly reflective cap layer 9 on the opening HL side is separated from the edge of the opening HL and positioned on the p-side electrode 5 outside the edge of the opening HL. In the peripheral portion of the p-side highly reflective cap layer 9 on the opening HL side, the edge portion of the p-side diffusion prevention layer 8 is formed to cover the edge portion of the p-side highly reflective layer 7, and the edge of the p-side diffusion prevention layer 8 is arranged inside the edge of the p-side highly reflective layer 7, in plan view.

The edge of the p-side highly reflective cap layer 9 on the element outer edge side is disposed on the upper surface of the fringe layer 6, where the edges of the p-side highly reflective layer 7 and the p-side diffusion prevention layer 8 coincide with each other. The structure that the edge portion of the p-side highly reflective cap layer 9 is positioned on the upper surface of the fringe layer 6, i.e. separated from the semiconductor layer surface, functions as a leakage stopper for Ag in the p-side highly reflective cap layer 9.

An insulating cap layer 10 is formed covering the p-side highly reflective cap layer 9 and the p-side electrode 5. The insulating cap layer 10 and the fringe layer 6 cover the p-side highly reflective cap layer 9 and the p-side electrode 5, and thereby suppress diffusion of Ag. For example, a SiO₂ film having a film thickness of 300 nm is deposited by sputtering and patterned by lift-off. As for the patterning method, besides lift-off, such a method in which a SiO₂ film is formed on the entire surface, and thereafter dry etching is performed by using a CF₄ based gas, or the like may be employed.

The insulating cap layer 10 can be formed by using an insulating material, e.g. SiO₂ or SiN. The insulating cap layer 10 has a function of preventing leakage of the Ag based material used for the p-side electrode 5 and the p-side highly reflective layer 7 of the p-side highly reflective cap layer 9.

The insulating cap layer 10 is also formed in the vicinity of the edge of the opening HL and is formed in such a way as to be extended on the side surface of the p-side electrode 5 defining the opening HL. The insulating cap layer 10 has openings corresponding to the openings HL and exposes the p-type GaN layer 4 at the bottoms of the openings.

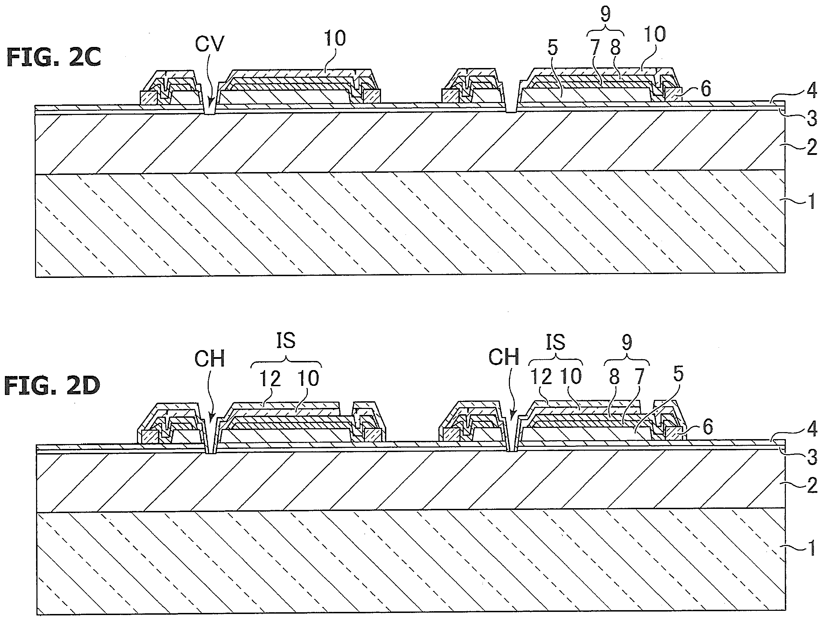

As shown in Fig. 2C, the p-type GaN layer 4 exposed at the opening and the light-emitting layer 3 thereunder are removed by, for example, reactive ion etching (RIE) to form an concave portion or a cavity portion CV. Etching is performed crossing the pn junction region including the light-emitting layer 3 to the depth at which the n-type semiconductor layer 2 is electrically exposed. The contact region for the n-side electrode of the n-type semiconductor layer 2 is ensured.

As shown in Fig. 2D, an insulating float layer 12 of an insulating material, e.g. silicon oxide or silicon nitride, is formed by sputtering, and is patterned for example by etching using a CF₄ based gas. The insulating float layer 12 covers the pn junction region exposed at the side surface of the concave portion CV and has an opening at the bottom of the concave portion CV to expose the n-type semiconductor layer 2. The insulating float layer 12 also covers the insulating cap layer 10. In the drawing, the outer circumference surface of the fringe layer 6 is covered, although not indispensable. An interelectrode insulating layer IS is formed by stacking the insulating cap layer 10 and the insulating float layer 12.

In order to ensure the contact region for the p-side electrode, an etching mask having an opening on part of the region where the p-side highly reflective cap layer 9 exists thereunder, and the insulating float layer 12 and the insulating cap layer 10 are etched by, for example, dry etching with a CF₄ based gas to form a contact hole exposing part of the p-side highly reflective cap layer 9.

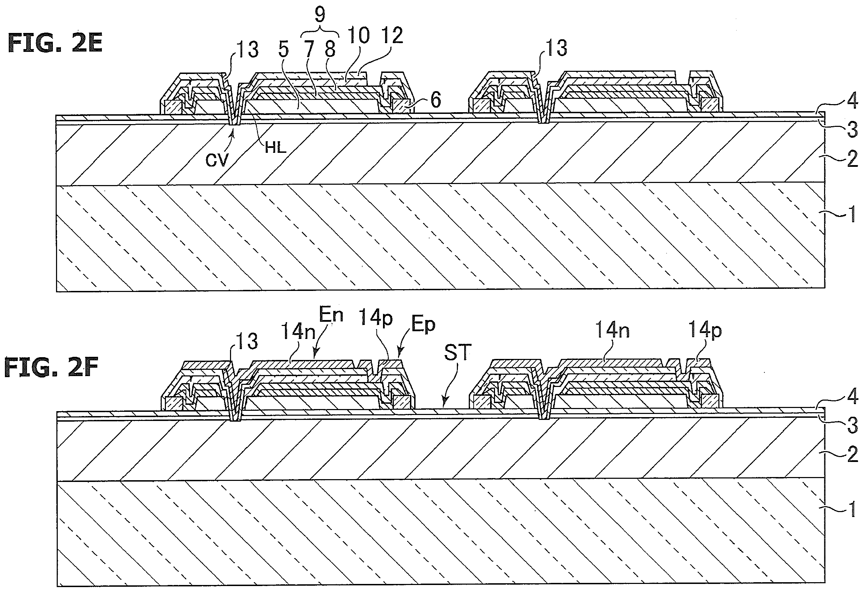

As shown in Fig. 2E, a highly reflective n-side electrode 13 is formed covering the insulating float layer 12 on the concave portion CV surface, overlapping the p-side electrode 5. For example, the highly reflective n-side electrode 13 is formed in the region on the insulating float layer 12 and on the n-type semiconductor 2 exposed at the bottom of the concave portion CV by stacking Ti/Ag/Ti/Pt/Au having a film thickness of 1/200/100/200/200 (nm) through electron beam evaporation or sputtering and is patterned by lift-off or the like. The highly reflective n-side electrode 13 serves as a connection electrode in contact with the n-type semiconductor layer 2 at the bottom of the concave portion CV, and in addition, also serves as a highly reflective mirror with respect to the lights incident from the lower side in the drawing. The highly reflective n-side electrode 13 is formed in such a way that the peripheral portion thereof overlaps the peripheral portion of the p-side electrode 5 defining the opening HL, in plan view. If the Ti layer as the lowermost layer is thick, the reflectance is reduced. Therefore, the film thickness of this Ti layer is selected to be 5 nm or less, for example, 1 nm. The high reflectance based of the Ag layer, which is the second layer from the bottom, is ensured.

As shown in Fig. 2F, cap layers 14n and 14p serving as connection electrodes are formed by bonding or fusing. For example, a cap electrode 14 including an n-side cap electrode 14n and a p-side cap electrode 14p is formed by stacking Ti/Pt/Au having a film thickness of 50/100/400 (nm) through electron beam evaporation or sputtering and patterned by lift-off or the like. The lowermost layer of the cap electrode 14 is the Ti layer having a thickness of 50 nm, which has a high absorptivity (optical absorption). The highly reflective electrode 13 and the cap layer 14n can also be collectively considered to be n-side electrode. The n-side electrode defines the cavity in the concave portion CV of the via hole.

The n-side cap electrode 14n is connected to the n-side electrode 13 and forms an n-side electrode EN of the element. The p-side cap electrode 14p enters the contact hole and is connected with the p-side highly reflective cap layer 9. The p-side cap electrode 14p is isolated from the n-side cap layer 14n with a gap therebetween. The p-side electrode 5, the p-side highly reflective cap layer 9, and the p-side connection electrode 14p form a p-side electrode Ep of the element.

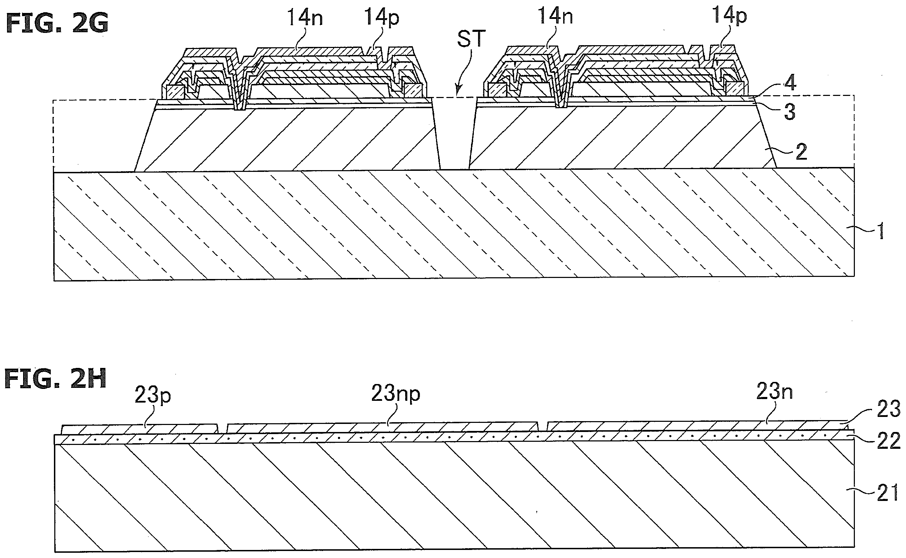

As shown in Fig. 2G, a photoresist mask covering the LED element region and having opening which exposes the outside region is used. The p-type semiconductor layer 4, the light-emitting layer 3, and the n-type semiconductor layer 2 are etched by reactive dry etching (RIE) for example by using chlorine (Cl) gas to expose the growth substrate 1. The LED elements are patterned and streets ST isolating adjacent LED elements are formed.

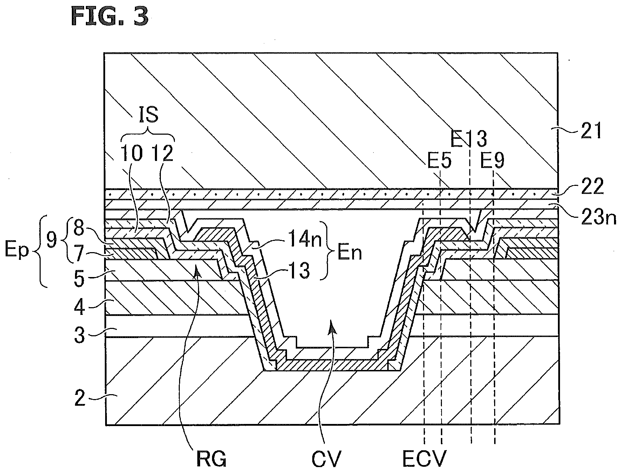

Fig. 3 is a schematic sectional view in the vicinity of the n-side electrode 13.

The concave portion CV is formed in the opening formed in the p-side electrode 5, and the n-type semiconductor layer 2 is exposed at the bottom. The opening edge E5 of the p-side electrode 5 is separated from the edge ECV of the p-type semiconductor layer 4 and is disposed on the p-type semiconductor layer 4. The p-side highly reflective cap layer 9 is disposed on outer side of the edge of the p-side electrode 5. The region in which the p-side highly reflective cap layer 9 is not present is denoted by RG. The n-side electrode 13 is in contact with the n-type semiconductor layer 2 at the bottom of the concave portion CV, is extended along the side surface of the concave portion CV, crosses the edge, and crosses the edge E5 of the p-side electrode 5, and terminates above the region RG.

The n-side electrode 13 is formed to overlap the peripheral portion of the p-side electrode 5 without gap outside the opening, in plan view. The n-side electrode 13 does not overlap the p-side highly reflective cap layer 9. The n-side cap layer 14n overlaps the p-side highly reflective cap layer 9, in plan view.

The interelectrode insulating layer IS rides on the upper surface of the p-side highly reflective cap layer 9 in the region outside the edge E9 of the p-side highly reflective cap layer 9. The height of the upper surface of the edge portion of the n-side electrode 13 formed riding on the region RG is lower than the height of the interelectrode insulating layer IS upper surface in the region outside the edge E9. Fig. 3 shows a state in which the support substrate 21 provided with an insulating layer 22 and an electrode 23 is coupled in a following step.

The light extraction efficiency can be improved by allowing the light incident from the light-emitting layer to be reflected at the n-side electrode 13 in the opening and be reflected at the p-side electrode Ep in the outside thereof. The edge portion of the n-side electrode 13 is terminated above the region RG, so that multiple reflection between the p-side electrode Ep and the n-side electrode 13 is restricted, and thereby, color phase irregularity and the like at the light-emitting layer edge portion can be suppressed.

A plurality of n-side electrodes connected to the n-type semiconductor layer are disposed in the element. For example, n-side electrodes are arranged in matrix shape with a plurality of rows and a plurality of columns, e.g. 6 rows and 12 columns or 8 rows and 16 columns, in the light-emitting surface having a short side length of about 0.6 mm to 0.8 mm and a long side length about 1.5 to 2.5 times the short side length.

In general, metal and semiconductor have different thermal expansion coefficients. In case when a plurality of via holes are formed in the semiconductor layer and metal electrode is embedded in each via hole, a stress applied to the semiconductor layer may increase because of thermal deformation associated with the element operation.

In case when a structure including a cavity CV, as shown in Fig. 3, is used as the n-side electrode, effects of suppressing the stress and releasing the generated stress are expected. These effects are merits other than the improvement of the brightness distribution and the color distribution in the light emitting surface of the LED.

The explanation of the production steps of a semiconductor light-emitting device according to the embodiment will be continued with reference to Fig. 2H to Fig. 2L. A two-gang (two combined) light-emitting device having a structure in which two light-emitting elements 31A and 31B are connected in series will be described as an example. The numbers of LED chips can be changed according to necessity. For example, a four-gang (four combined) semiconductor light-emitting device can also be formed.

As shown in Fig. 2H, for example, a silicon substrate is used as a support substrate 21. An insulating layer 22 made of SiO₂ is formed on the surface of the support substrate by thermal oxidation process. It is preferable that the support substrate 21 is formed from a material having a thermal expansion coefficient close to the thermal expansion coefficients of sapphire (7.5 × 10⁻⁶/K) and GaN (5.6 × 10⁻⁶/K), and high thermal conductivity. For example, Si, AlN, Mo, W, CuW, and the like can be used. The film thickness of the insulating layer 22 may be the thickness which can achieve the purpose of ensuring the insulating property.

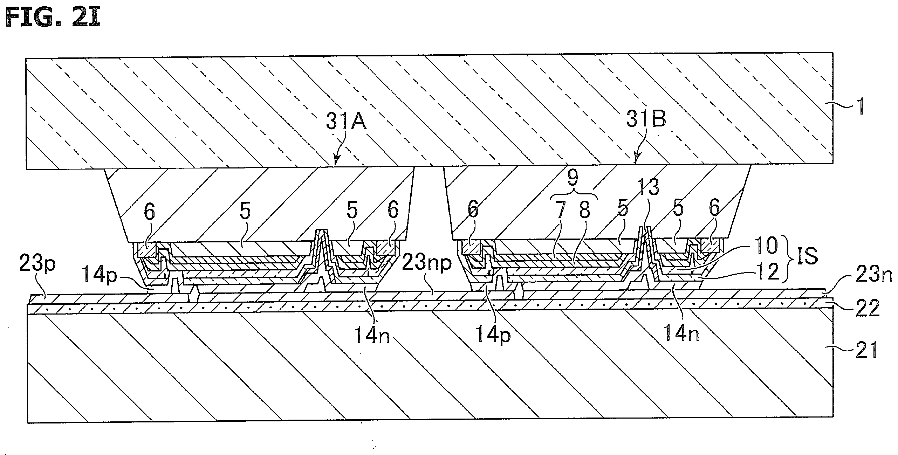

Subsequently, a fusing (or adhesion) layer 23 serving as support substrate side wiring or electrode is formed on the insulating layer 22. For example, AuSn (Sn: 20 percent by weight) film having a film thickness of 1 µm is deposited by resistance heating evaporation and patterned into a plurality of parts (the number of LED elements + 1, here three parts). As shown in Fig. 2I, the wiring or electrode 23 of the support substrate side is bonded to the n-side electrode 14n and p-side electrode 14p on the element side. As for the materials for the support substrate side electrode 23 serving as a bonding layer for sticking, the n-side electrode 14n, and the p-side electrode 14p, metals containing Au-Sn, Au-In, Pd-In, Cu-Sn, Ag-Sn, Ag-In, Ni-Sn, and the like capable of fusion bonding and metals containing Au capable of diffusion bonding can be used.

An electrode 23p connected to the p-side electrode 14p of a light-emitting element 31A, an electrode 23np connected to the n-side electrode 14n of the light-emitting element 31A and the p-side electrode 14p of the light-emitting element 31B, and an electrode 23n connected to the n-side electrode 14n of the light-emitting element 31B are formed on the support substrate 21 while being electrically isolated.

As shown in Fig. 2I, the electrodes 23p, 23np, and 23n on the support substrate side and the p-side electrode 14p and the n-side electrode 14n of each element are aligned and bonded. For example, pressurized state under pressure of 3 MP at heated state of 300°C is maintained for 10 minutes. Thereafter, the structure is allowed to cool down to room temperature. In this manner, fusing bonding is performed by thermocompression bonding.

An electrical connection structure is formed, wherein the p-side electrode 14p of the light-emitting element 31A is led by the electrode 23p, the n-side electrode 14n of the light-emitting element 31A and the p-side electrode 14p of the light-emitting element 31B are connected in series by the electrode 23np, and the n-side electrode 14n of the light-emitting element 31B is led by the electrode 23n.

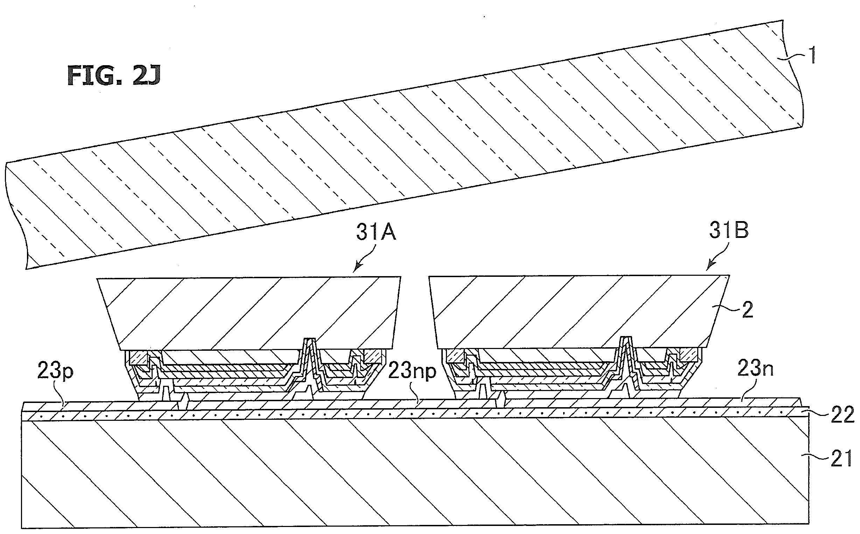

As shown in Fig. 2J, the growth substrate 1 is removed by laser lift-off. For example, UV excimer laser light is applied from the back surface side of the sapphire substrate 1 to heat and thermally decompose the buffer layer. Etching or other methods may be used for removing the growth substrate 1.

Then, Ga generated by laser lift-off is removed with hot water or the like, and the surface is treated with hydrochloric acid. Consequently, the n-type GaN layer 2 is exposed. This surface treatment is only need to etch a nitride semiconductor and chemical agents of acids, alkalis, and the like, e.g. phosphoric acid, sulfuric acid, KOH, and NaOH, can also be used. The surface treatment may be performed by dry etching through Ar plasma or chlorine based plasma, polishing, or the like. In addition, the surface of the n-type GaN layer 2 is subjected to a CI, Ar treatment by using a dry etching apparatus, e.g. RIE, or a smoothing treatment by using a CMP apparatus to remove laser traces and a laser damage layer.

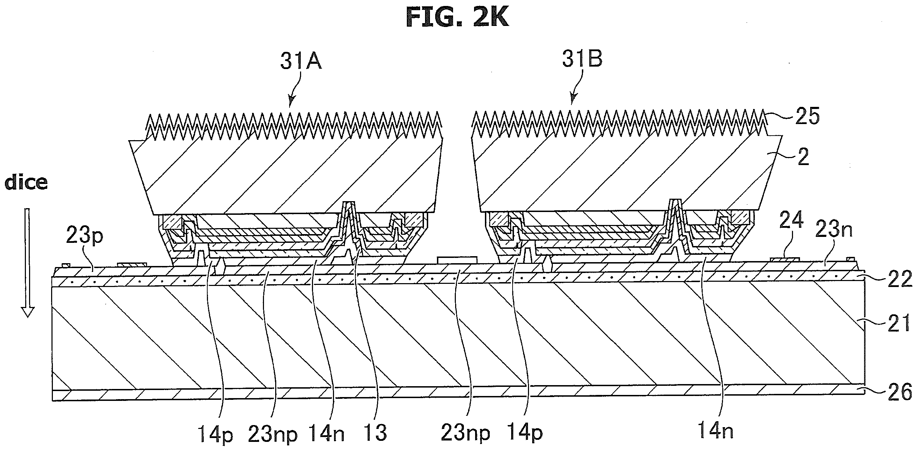

As shown in Fig. 2K, a light extraction structure or a micro cone structure is formed. The exposed surface of the n-type GaN layer 2 is dipped into an alkaline solution, e.g. a KOH solution, to subject the surface of the n-type GaN layer 2 to roughening (forming micro cone structure), resulting from a crystal structure. The light extraction efficiency can be improved.

In the regions outside the outer edge of the electrodes 23p and 23n on the support substrate, glare light absorption layers 24 are formed except the regions to be subjected to wire bonding later. For example, Ti having a thickness of 200 nm is deposited by electron beam evaporation or the like and patterning is performed.

An opening is formed in the region to be subjected to the wire bonding, and thereby, a AuSn layer of the support substrate electrode 23 is exposed. The glare light absorption layer 24 is formed to cover the outside of the opening with a Ti layer. The Ti layer easily absorbs yellow light generated from a fluorescent (phosphor) layer formed covering the element later as compared with the AuSn layer. Consequently, the yellow light is absorbed by the Ti layer 24 in the region around the wire bonding, so that the color irregularity or color separation in the peripheral portions of the light-emitting device can be suppressed.

A full-surface protective film 25 is formed by, for example, depositing SiO₂ having a thickness of 350 nm on the entire upper surface of the element through chemical vapor deposition (CVD) or the like.

In order to reduce the thermal resistance, the thickness of the support substrate 21 is reduced to, for example, 300 µm by grinding or polishing of the back surface side. In order to ensure the adhesion between the mounting substrate and the bonding material, a rear surface metal layer 26 is formed on the rear surface of the support substrate 21 by, for example, depositing Ti/Pt/Au having a thickness of 50 nm/15 nm/200 nm through electron beam evaporation. The support substrate 21 is divided by laser scribe or dicing 27 to serve as a unit of the semiconductor light-emitting device.

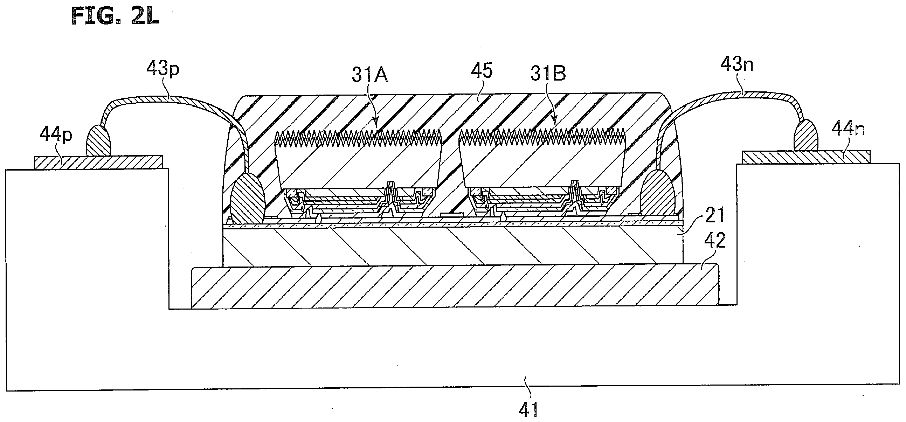

As shown in Fig. 2L, the support substrate 21 including the elements 31A and 31B is subjected to die bonding. The support substrate 21 is die bonded to bottom surface of an accommodation space of a package substrate 41 by using a bonding material 42, e.g. Ag paste or AuSn. Thereafter, wire bonding is performed by using Au wires 43p and 43n, and thereby, the p-side electrode of the element 31A and the n-side electrode of the element 31B are connected to power feed pads 44p and 44n, respectively, disposed on a sidewall of the package substrate 41.

The light-emitting elements 31A and 31B are sealed with a resin layer, and cured, so that a seal resin layer 45 is formed. A fluorescent powder for whitening the output lights is mixed in the seal resin. For example, a yellow-emitting fluorescent powder is mixed into the seal resin layer of the blue-emitting element. The emission wavelength and the fluorescent materials can be combined variously. Fluorescent materials of two colors of blue and yellow, three colors of red, green and blue, and the like can be mixed. As described above, the semiconductor light-emitting device is formed.

In the above-described configuration, the n-side electrodes are connected to the n-type semiconductor layer in a multiplicity of via holes formed penetrating the p-type semiconductor layer and the light-emitting layer and are connected to the connection electrode 14 extended above the p-side electrode. In the n-type semiconductor layer, the resistance component increases in accordance with the distance from the n-side electrode, hence the current density may decrease, and the brightness may be reduced. In order to suppress the brightness distribution, it may be effective to increase the density of the n-side electrodes and decrease the distance from each point in the semiconductor layer to a closest n-side electrode. However, when the density of the n-side electrodes increases, it is not preferable that the occupation area of the n-side electrodes in the semiconductor layer increases and the light-emitting region decreases. If the current density per unit area of the semiconductor light-emitting region is too large, the current conversion efficiency is reduced. In order to obtain a high current conversion efficiency, it is effective to suppress the current density per unit area of the semiconductor.

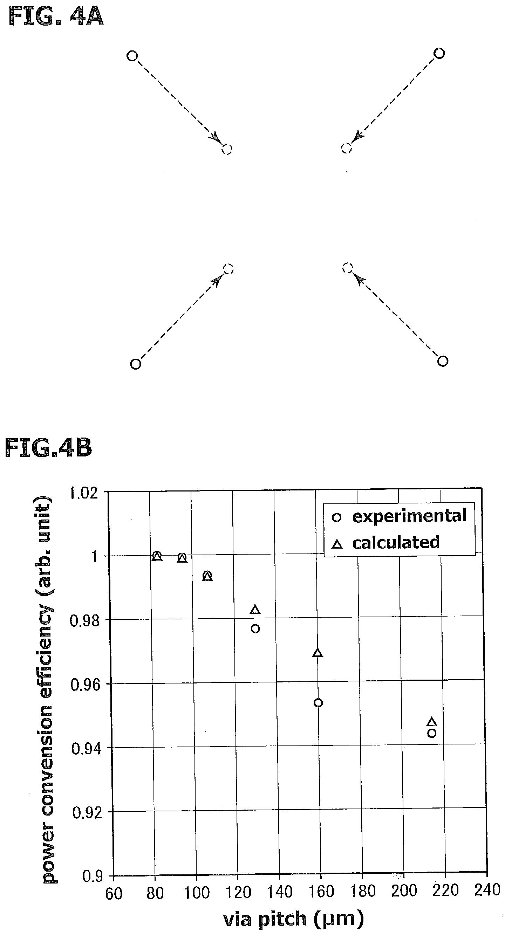

As shown in Fig. 4A, the case is considered where the pitch of the n-side electrodes is changed in the configuration, in which the n-side electrodes are arranged in square matrix, while the contact area with the n-type semiconductor layer is constant. The power conversion efficiencies when the via (n-side electrode) pitch (center-to-center distance) is changed to 215 µm, 160 µm, 130 µm, 107 µm, 95 µm, and 83 µm are calculated by simulation. In the drawing, only the closest four n-side electrodes are shown. A multiplicity of n-side electrodes are arranged vertically and horizontally at the same pitch. When the electrode pitch decreases, the distance from the four electrodes to the farthest center position decreases and the resistance component is reduced.

Fig. 4B is a graph showing changes in the power conversion efficiency relative to changes in the via pitch. The abscissa indicates via pitch in µm and the ordinate indicates power conversion efficiency in arbitrary unit. The power conversion efficiency is normalized by the maximum value. Plots indicated by symbol Δ show calculated values. As the via pitch is decreased from 215 µm, to 160 µm, 130 µm, 107 µm, and 95 µm, the power conversion efficiency substantially linearly increases. It is considered that the resistance component is reduced due to a decrease in the via pitch and the power conversion efficiency is improved. When the via pitch is further decreased to 83 µm, there appears a tendency that the power conversion efficiency slightly increases but is almost saturated. It is considered that reduction in the via pitch induces decrease in the light-emitting area, to increase the current density, which decreases the power conversion efficiency, and thereby, the merit due to reduction in the resistance component is canceled.

Then, following the above-described embodiment, samples were formed in which the pitch of the n-side electrodes arranged in square matrix was changed, as 215 µm, 160 µm, 130 µm, 107 µm, 95 µm, and 83 µm, as described above, and the power conversion efficiencies was measured. In Fig. 4B, plots indicated by symbol O show the measured results. It can be said that the characteristics of the calculated values and the measured values agree well with each other as a whole, although some differences are observed in intermediate region. It is experimentally confirmed that a high power conversion efficiency can be obtained by arranging small electrodes at a short pitch. Regarding the characteristics represented in Fig. 4B, the contact area of the n-side electrodes was designed to be constant, and therefore, all contact voltage drops of the n-side electrodes are same. When the contact area of the n-side electrodes is increased, the contact voltage drop of the n-side electrode will be reduced, and this will lead to improvement in the power conversion efficiency. On the other hand, increase in the contact area of the n-side electrodes will accompany reduction in area of the light-emitting region. This leads to increase in the current density and will cause reduction in the power conversion efficiency. Such dependency of the power conversion efficiency on the n-side electrode contact area was estimated by calculation. The electrical characteristics in case when the diameter of a circular contact region between the n-side electrode and the n-type semiconductor layer formed at the bottom of one concave portion CV, can be estimated from the results represented in Fig. 4B and changes in the contact area of the n-side electrode. Also, it is possible to obtain the relation between the current density and light output density from the experimental results of the current versus the light output characteristics, and from the resulting characteristics, it is possible to estimate how the current versus the light output characteristics change in case when the size of the n-side electrode is changed to change the area of the light-emitting region.

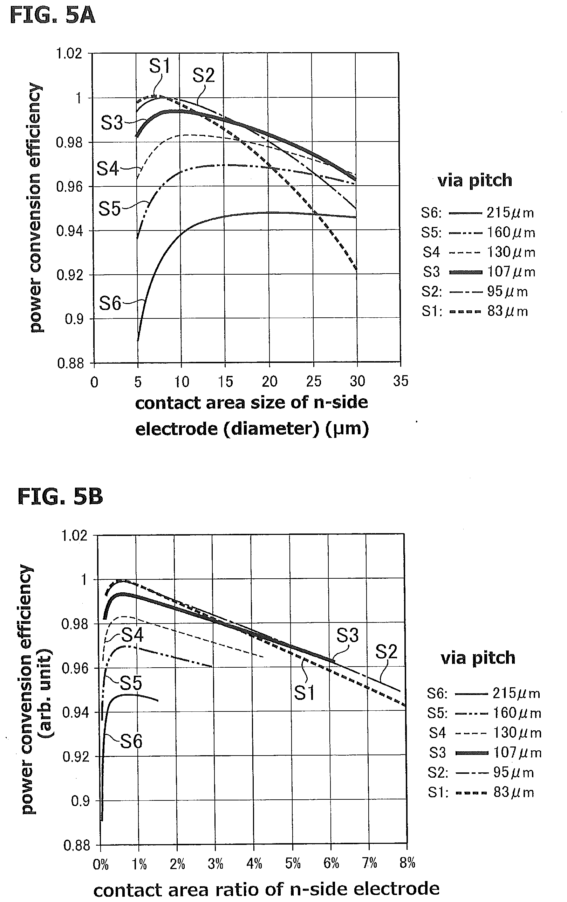

Figs. 5A and 5B show the results of the simulation. In Fig. 5A, the abscissa indicates the contact area size (diameter) of the n-side electrode in µm, and the ordinate indicates the normalized power conversion efficiency in arbitrary unit. In Fig. 5B, the abscissa indicates the ratio of the contact area of the n-side electrode in %, and the ordinate indicates the normalized power conversion efficiency in arbitrary unit. In both graphs, it is clear that the power conversion efficiencies of sample S1 with a via pitch set at 83 µm and sample S2 with a via pitch set at 95 µm are excellent. The contact area size (diameter) of the n-side electrode is preferably less than 10 µm (5 µm or more), and further preferably 6 µm to 9 µm. The ratio of the contact area of the n-side electrode is preferably less than 1% (0.3% or more), and further preferably 0.35% to 0.9%. Here, the term "to" refers to the range including both ends, that is, or more and or less.

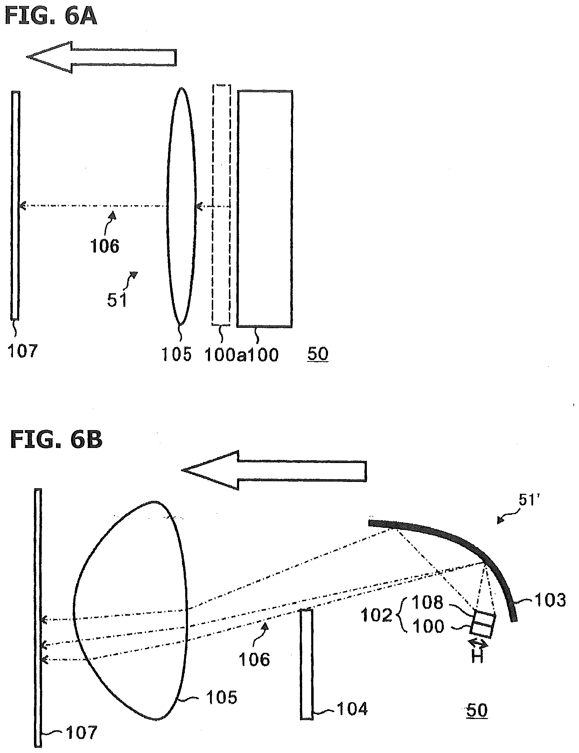

A vehicle illumination apparatus (headlamp) incorporated with the LED according to the above-described embodiment will be described. Fig. 6A and Fig. 6B are schematic sectional views showing vehicle illumination apparatus according to application examples.

A vehicle illumination apparatus 50 shown in Fig. 6A is an example in which an irradiation lens 105 is used as an irradiation optical system 51. The irradiation lens 105 is set in such a way that a light source image 106 of an LED array 100 is projected on a virtual vertical screen (irradiation surface) 107 confronting the vehicle front end portion.

Fig. 6B shows an example of the vehicle illumination apparatus 50 having another irradiation optical system 51'. As shown in Fig. 6B, the irradiation optical system 51' may include a multi-reflector (reflective surface) 103 and an irradiation lens 105. The vehicle illumination apparatus 50 according to this example is configured to include a light source 102 formed with fluorescent (phosphor) layer (wavelength conversion layer) 108 covering the light-emitting surface of the LED array 100 and the irradiation optical system 51' including the reflective surface 103 serving as a multi-reflector divided into a plurality of small reflective regions, a shade 104, and the irradiation lens 105.

As shown in Fig. 6B, the light source 102 is arranged to have irradiation direction (light-emitting surface) directed upward and the reflective surface 103 is a spheroidal reflective surface with a first focal point set in the vicinity of the light source 102 and a second focal point set in the vicinity of the upper end edge of the shade 104. The reflector 103 is arranged to extend in the region from the side to the front of the light source 102 to accept the lights from the light source 102.

As shown in Fig. 6B, the reflective surface 103 is configured to irradiate the light source image 106 of the LED array 100 of the light source 102 toward the front of the vehicle in a predetermined light distribution shape, and to project the light source image 106 of the LED array 100 on a virtual vertical screen (irradiation surface) 107 at the vehicle front end portion.

The shade 104 is a light blocking member to block part of the reflected light from the reflective surface 103 and form a cut off line suitable for the headlamp and is arranged between the irradiation lens 105 and the light source 102 while the upper end edge is located in the vicinity of the focal point of the irradiation lens 105. The irradiation lens 105 is arranged on the vehicle front side and applies the reflected light from the reflective surface 103 to the irradiation surface 107.

The vehicle illumination apparatuses have been described as application examples of the LED array. It is also possible to apply the invention to other light-emitting devices, such as general illumination device, large backlight, and the like.

Although the present invention has been explained with reference to the embodiments hereinabove, the present invention is not limited to them. For example, instead of the GaN/InGaN multiple quantum-well, an InGaN/InGaN multiple quantum-well having a different composition may be used. A light-emitting layer other than the multiple quantum-well can also be used. The arrangement of the plurality of n-side electrodes is not limited to the shape of square matrix. For example, other matrix arrangement can be employed. The semiconductor material is not limited to GaN or AIGaInN. In addition, it is obvious to those skilled in the art that various modifications, improvements, combinations, and the like are possible.

## Claims

1. A semiconductor light-emitting element comprising:
a semiconductor laminate (2, 3, 4) containing a first conductivity type first semiconductor layer (2), a light-emitting layer (3) disposed on the first semiconductor layer (2), and a second semiconductor layer (4) which is disposed on the light-emitting layer (3) and which has a second conductivity type reverse to the first conductivity type;
a plurality of via holes (VH) formed in the semiconductor laminate (2, 3, 4) from the second semiconductor layer side, penetrating the light-emitting layer (3) and exposing the first semiconductor layer (2);
a second semiconductor layer side electrode (5) extending on the second semiconductor layer (4) and having light reflectivity, which is separated from each of the boundary edges of the second semiconductor layer (4) and the plurality of via holes (VH);
an insulating layer (12) which covers side surfaces of the via holes (VH) of at least the light-emitting layer (3) and the second semiconductor layer (4), which extends on the boundary edge portion of the second semiconductor layer side electrode (5), and which exposes at least part of the bottom of each of the plurality of via holes (VH); and
a plurality of first semiconductor layer side electrodes (13) which are electrically connected to the first semiconductor layer (2) at the bottom of each of the plurality of via holes (VH), which are led to above the second semiconductor layer (4) and the second semiconductor layer side electrode (5) with the insulating layer (12) intervening therebetween, which are disposed overlapping the second semiconductor layer side electrode (5) without gaps, in a plan view, and which have light reflectivity.

2. The semiconductor light-emitting element according to claim 1, comprising cavity portions defined by the first semiconductor layer side electrodes (13) in the via holes (VH).

3. The semiconductor light-emitting element according to claim 1,
wherein the semiconductor laminate (2, 3, 4) is formed of GaN containing semiconductors, the first conductivity type is an n-type, the second conductivity type is a p-type, and a light emitting surface is defined on the second semiconductor layer (4) side.

4. The semiconductor light-emitting element according to claim 1,
wherein each of the plurality of first semiconductor layer side electrodes (13) has a contact area of less than 10 µm in diameter.

5. The semiconductor light-emitting element according to claim 4,
wherein each of the plurality of first semiconductor layer side electrodes (13) has a contact area within the range of 6 µm to 9 µm in diameter.

6. The semiconductor light-emitting element according to claim 1,
wherein the contact area ratio of the total contact area of the plurality of first semiconductor layer side electrodes (13) to the area of the first semiconductor layer (2) is less than 1%.

7. The semiconductor light-emitting element according to claim 6,
wherein the contact area ratio of the total contact area of the plurality of first semiconductor layer side electrodes (13) to the area of the first semiconductor layer (2) is within the range of 0.35% to 0.9%.

8. The semiconductor light-emitting element according to claim 1,
wherein the first semiconductor layer side electrode (13) includes a metal reflective layer having high visible light reflectance and an ohmic property enhancing electrode layer disposed between the reflective layer and the first semiconductor layer (2).

9. The semiconductor light-emitting element according to claim 8,
wherein the reflective layer is made of one species of material selected from the group consisting of Ag, Pt, Ni, Al, Pd, and alloys thereof.

10. The semiconductor light-emitting element according to claim 8,
wherein the ohmic feature enhancing electrode layer is a Ti layer having a film thickness of 5 nm or less.

11. The semiconductor light-emitting element according to claim 1,
wherein the second semiconductor layer side electrode (5) contains Ag and a Ag diffusion suppressing element.

12. The semiconductor light-emitting element according to claim 1,
wherein the plurality of the first semiconductor layer side electrodes (13) contain a main portion arranged in a matrix.

13. The semiconductor light-emitting element according to claim 1,
wherein the surface of the first semiconductor layer (2) on opposite side to the light-emitting layer (3) has micro cone structure.

14. A semiconductor light-emitting device comprising:
a support substrate (21);
wiring layer (W) which is disposed on the support substrate (21), which includes a reflective metal layer as an uppermost layer, and which includes a plurality of portions; and
a plurality of semiconductor light-emitting elements as set forth in claim 1, arranged astride adjacent portions of the wiring layer (W) having the plurality of portions,
wherein the first semiconductor layer side electrodes (13) and the second semiconductor layer side electrode (5) are connected to the wiring layer (W).

15. The semiconductor light-emitting device according to claim 14, further comprising:
a seal resin layer (45) disposed covering the plurality of semiconductor light-emitting elements; and
fluorescent powder mixed in the seal resin layer (45).

16. The semiconductor light-emitting device according to claim 14,
wherein the plurality of semiconductor light-emitting elements are arranged along one direction and the wiring layer (W) connects the plurality of semiconductor light-emitting elements in series.

17. The semiconductor light-emitting device according to claim 14,
wherein the first semiconductor layer side electrodes (13) and the second semiconductor layer side electrode (5) have AuSn layers as uppermost layers and the wiring layer (W) includes an AuSn layer.

18. The semiconductor light-emitting device according to claim 14, further comprising
light absorbing layers disposed in such a way as to surround bonding regions above two portions arranged at outermost portions among the plurality of portions of the wiring layer (W).

19. The semiconductor light-emitting device according to claim 18, further comprising
a package provided with a bonding material disposed on bottom of an accommodation portion and a pair of power feed pads on side portions, and bonding wires (43),
wherein the bonding material fixes the support substrate (21) and the bonding wires (43) connect the power feed pads and the bonding regions.

20. The semiconductor light-emitting device according to claim 14, further comprising an optical system (51) for irradiating lights emitted from the semiconductor light-emitting elements toward predetermined direction, constructing an on-vehicle lighting structure.

## Patentansprüche

1. Halbleiterlichtemissionselement, welches Folgendes aufweist:
ein Halbleiterlaminat (2, 3, 4), welches eine Halbleiterschicht (2) eines ersten Leitfähigkeitstyps aufweist, weiter eine lichtemittierende Schicht (3), die auf der ersten Halbleiterschicht (2) angeordnet ist, und eine zweite Halbleiterschicht (4), die auf der lichtemittierenden Schicht (3) angeordnet ist, und die einen zweiten Leitfähigkeitstyp hat, der umgekehrt zum ersten Leitfähigkeitstyp ist;
eine Vielzahl von Via-Löchern bzw. Durchkontaktierungen (VH), die in dem Halbleiterlaminat (2, 3, 4) geformt sind, und zwar von der Seite der zweiten Halbleiterschicht die lichtemittierende Schicht (3) durchdringend und die erste Halbleiterschicht (2) freilegend;
eine Elektrode (5) auf der Seite der zweiten Halbleiterschicht, die sich auf der zweiten Halbleiterschicht (4) erstreckt und eine Lichtreflektivität hat, die von jeder der Begrenzungskanten der zweiten Halbleiterschicht (4) und der Vielzahl von Durchkontaktierungen (VH) getrennt ist;
eine Isolierschicht (12), welche Seitenflächen der Durchkontaktierungen (VH) von mindestens der lichtemittierenden Schicht (3) und der zweiten Halbleiterschicht (4) bedeckt, die sich auf den Begrenzungskantenteil der Elektrode (5) auf der Seite der zweiten Halbleiterschicht erstreckt, und die zumindest einen Teil des Unterteils von jeder der Vielzahl von Durchkontaktierungen (VH) freilegt; und
eine Vielzahl von Elektroden (13) auf der Seite der ersten Halbleiterschicht, die elektrisch mit der ersten Halbleiterschicht (2) am Unterteil von jeder der Vielzahl von Durchkontaktierungen (VH) verbunden sind, die zu oberhalb der zweiten Halbleiterschicht (4) und der Elektrode (5) auf der Seite der zweiten Halbleiterschicht geführt sind, wobei die isolierende Schicht (12) dazwischen angeordnet ist, welche überlappend mit der Elektrode (5) auf der Seite der zweiten Halbleiterschicht ohne Spalte in einer Draufsicht angeordnet sind, und die Lichtreflektivität haben.

2. Halbleiterlichtemissionselement nach Anspruch 1, welches Hohlraumteile aufweist, die durch die Elektroden (13) auf der Seite der ersten Halbleiterschicht in den Durchkontaktierungen (VH) definiert werden.

3. Halbleiterlichtemissionselement nach Anspruch 1, wobei das Halbleiterlaminat (2, 3, 4) aus GaN-enthaltenden Halbleitern geformt ist, wobei der erste Leitfähigkeitstyp ein n-Typ ist, wobei der zweite Leitfähigkeitstyp ein p-Typ ist, und wobei eine lichtemittierende Oberfläche auf der Seite der zweiten Halbleiterschicht (4) definiert ist.

4. Halbleiterlichtemissionselement nach Anspruch 1, wobei jede der Vielzahl von Elektroden (13) auf der Seite der ersten Halbleiterschicht eine Kontaktfläche von weniger als 10 µm im Durchmesser hat.

5. Halbleiterlichtemissionselement nach Anspruch 4, wobei jede der Vielzahl von Elektroden (13) auf der Seite der ersten Halbleiterschicht eine Kontaktfläche im Bereich von 6 µm bis 9 µm im Durchmesser hat.

6. Halbleiterlichtemissionselement nach Anspruch 1, wobei das Kontaktflächenverhältnis der gesamten Kontaktfläche der Vielzahl von Elektroden (13) auf der Seite der ersten Halbleiterschicht zu der Fläche der ersten Halbleiterschicht (2) geringer als 1 % ist.

7. Halbleiterlichtemissionselement nach Anspruch 6, wobei das Kontaktflächenverhältnis der gesamten Kontaktfläche der Vielzahl von Elektroden (13) auf der Seite der ersten Halbleiterschicht zu der Fläche der ersten Halbleiterschicht (2) im Bereich von 0,35 % bis 0,9 % ist.

8. Halbleiterlichtemissionselement nach Anspruch 1, wobei die Elektroden (13) auf der Seite der ersten Halbleiterschicht eine reflektierende Metallschicht bzw. Metallreflexionsschicht mit einer hohen Reflektivität für sichtbares Licht aufweist, und eine Elektrodenschicht zur Verbesserung der Ohm'schen Eigenschaft, die zwischen der reflektierenden Schicht bzw. Reflexionsschicht und der ersten Halbleiterschicht (2) angeordnet ist.

9. Halbleiterlichtemissionselement nach Anspruch 8, wobei die reflektierende Schicht aus einer Materialart gemacht ist, die aus der Gruppe ausgewählt ist, die aus Ag, Pt, Ni, Al, Pd und Legierungen davon besteht.

10. Halbleiterlichtemissionselement nach Anspruch 8, wobei die Elektrodenschicht zur Verbesserung der Ohm'schen Eigenschaft eine Ti-Schicht mit einer Schichtdicke von 5 nm oder weniger ist.

11. Halbleiterlichtemissionselement nach Anspruch 1, wobei die Elektrode (5) auf der Seite der zweiten Halbleiterschicht Ag und ein Ag-Diffusionsunterdrückungselement enthält.

12. Halbleiterlichtemissionselement nach Anspruch 1, wobei die Vielzahl der Elektroden (13) auf der Seite der ersten Halbleiterschicht einen Hauptteil enthält, der in einer Matrix angeordnet ist.

13. Halbleiterlichtemissionselement nach Anspruch1, wobei die Oberfläche der ersten Halbleiterschicht (2) auf der entgegengesetzten Seite zur lichtemittierenden Schicht (3) eine Mikrokegelstruktur hat.

14. Halbleiterlichtemissionsvorrichtung, die Folgendes aufweist:
ein Tragsubstrat (21);
eine Verdrahtungsschicht (W), die auf dem Tragsubstrat (21) angeordnet ist, die eine reflektierende Metallschicht als eine oberste Schicht aufweist, und die eine Vielzahl von Teilen aufweist; und
eine Vielzahl von Halbleiterlichtemissionselementen nach Anspruch 1, die aufgesetzt auf benachbarte Teile der Verdrahtungsschicht (W) mit der Vielzahl von Teilen angeordnet sind,
wobei die Elektroden (13) auf der Seite der ersten Halbleiterschicht und die Elektrode (5) auf der Seite der zweiten Halbleiterschicht mit der Verdrahtungsschicht (W) verbunden sind.

15. Halbleiterlichtemissionsvorrichtung nach Anspruch 14, die weiter Folgendes aufweist:
eine Dichtungskunststoffschicht (45), die so angeordnet ist, dass sie die Vielzahl von Halbleiterlichtemissionselementen abdeckt; und
fluoreszierendes Pulver, welches mit der Dichtungskunststoffschicht (45) gemischt ist.

16. Halbleiterlichtemissionsvorrichtung nach Anspruch 14, wobei die Vielzahl von Halbleiterlichtemissionselementen entlang einer Richtung angeordnet sind, und wobei die Verdrahtungsschicht (W) die Vielzahl von Halbleiterlichtemissionselementen in Reihe verbindet.

17. Halbleiterlichtemissionsvorrichtung nach Anspruch 14, wobei die Elektroden (13) auf der Seite der ersten Halbleiterschicht und die Elektrode (5) auf der Seite der zweiten Halbleiterschicht AuSn-Schichten als oberste Schichten haben, und wobei die Verdrahtungsschicht (W) eine AuSn-Schicht aufweist.

18. Halbleiterlichtemissionsvorrichtung nach Anspruch 14, die weiter lichtabsorbierende Schichten aufweist, die derart angeordnet sind, dass sie Bonding- bzw. Verbindungsregionen über zwei Teilen umgeben, die an den äußersten Teilen unter der Vielzahl von Teilen der Verdrahtungsschicht (W) angeordnet sind.

19. Halbleiterlichtemissionsvorrichtung nach Anspruch 18, die weiter Folgendes aufweist:
eine Packung, die mit einem Bonding- bzw. Verbindungsmaterial versehen ist, welches an einem Unterteil eines Aufnahmeteils angeordnet ist, und mit einem Paar von Leistungseinspeisungskissen an Seitenteilen, und Verbindungsdrähte (43),
wobei das Bonding- bzw. Verbindungsmaterial das Tragsubstrat (21) fixiert, und wobei die Verbindungsdrähte (43) die Leistungseinspeisungskissen und die Verbindungsbereiche verbinden.

20. Halbleiterlichtemissionsvorrichtung nach Anspruch 14, die weiter ein optisches System (51) aufweist, um Licht, welches von den Halbleiterlichtemissionselementen ausgestrahlt wird, zu einer vorbestimmten Richtung zu strahlen, wodurch eine Fahrzeugbeleuchtungsstruktur aufgebaut wird.

## Revendications

1. Élément électroluminescent à semiconducteur comprenant :
un stratifié semiconducteur (2, 3, 4) contenant une première couche semiconductrice d'un premier type de conductivité (2), une couche électroluminescente (3) disposée sur la première couche semiconductrice (2), et une deuxième couche semiconductrice (4) qui est disposée sur la couche électroluminescente (3) et qui a un deuxième type de conductivité inverse du premier type de conductivité ;
une pluralité de trous d'interconnexion (VH) formés dans le stratifié semiconducteur (2, 3, 4) à partir du côté de la deuxième couche semiconductrice, pénétrant dans la couche électroluminescente (3) et exposant la première couche semiconductrice (2) ;
une électrode latérale de la deuxième couche semiconductrice (5) s'étendant sur la deuxième couche semiconductrice (4) et ayant une réflectivité lumineuse, qui est séparée de chacun des bords limites de la deuxième couche semiconductrice (4) et de la pluralité de trous d'interconnexion (VH) ;
une couche isolante (12) qui recouvre les surfaces latérales des trous d'interconnexion (VH) d'au moins la couche électroluminescente (3) et de la deuxième couche semiconductrice (4), qui s'étend sur la partie de bord limite de l'électrode du côté de la deuxième couche semiconductrice (5), et qui expose au moins une partie du fond de chaque trou de la pluralité de trous d'interconnexion (VH) ; et
une pluralité d'électrodes du côté de la première couche semiconductrice (13) qui sont électriquement connectées à la première couche semiconductrice (2) au fond de chaque trou de la pluralité de trous d'interconnexion (VH), qui sont conduites au-dessus de la deuxième couche semiconductrice (4) et de l'électrode du côté de la deuxième couche semiconductrice (5) avec la couche isolante (12) interposée entre celles-ci, qui sont disposées en chevauchant l'électrode du côté de la deuxième couche semiconductrice (5) sans espace, dans une vue en plan, et qui ont une réflectivité lumineuse.

2. Élément électroluminescent à semiconducteur selon la revendication 1, comprenant des parties de cavité définies par les électrodes du côté de la deuxième couche semiconductrice (13) dans les trous d'interconnexion (VH).

3. Élément électroluminescent à semiconducteur selon la revendication 1, dans lequel le stratifié semiconducteur (2, 3, 4) est formé de semiconducteurs contenant du GaN, le premier type de conductivité est de type n, le deuxième type de conductivité est de type p, et une surface électroluminescente est définie du côté de la deuxième couche semiconductrice (4).

4. Élément électroluminescent à semiconducteur selon la revendication 1, dans lequel chaque électrode de la pluralité des électrodes du côté de la première couche semiconductrice (13) a une zone de contact de moins de 10 µm de diamètre.

5. Élément électroluminescent à semiconducteur selon la revendication 4, dans lequel chaque électrode de la pluralité des électrodes du côté de la première couche semiconductrice (13) a une zone de contact dans la plage allant de 6 µm à 9 µm en diamètre.

6. Élément électroluminescent à semiconducteur selon la revendication 1, dans lequel le rapport de la zone de contact de la zone de contact totale de la pluralité des électrodes du côté de la première couche semiconductrice (13) à la zone de la première couche semiconductrice (2) est inférieur à 1 %.

7. Élément électroluminescent à semiconducteur selon la revendication 6, dans lequel le rapport de la zone de contact de la zone de contact totale de la pluralité d'électrodes du côté de la première couche semiconductrice (13) à la zone de la première couche semiconductrice (2) est dans la plage allant de 0,35 % à 0,9 %.

8. Élément électroluminescent à semiconducteur selon la revendication 1, dans lequel l'électrode du côté de la première couche semiconductrice (13) comporte une couche réfléchissante métallique ayant une réflectivité lumineuse élevée et une couche d'électrode améliorant les propriétés ohmiques disposée entre la couche réfléchissante et la première couche semiconductrice (2).

9. Élément électroluminescent à semiconducteur selon la revendication 8, dans lequel la couche réfléchissante est constituée d'un type de matériau choisi dans le groupe constitué de Ag, Pt, Ni, Al, Pd et de leurs alliages.

10. Élément électroluminescent à semiconducteur selon la revendication 8, dans lequel la couche d'électrode améliorant les propriétés ohmiques est une couche de Ti ayant une épaisseur de film de 5 nm ou moins.

11. Élément électroluminescent à semiconducteur selon la revendication 1, dans lequel l'électrode du côté de la deuxième couche semiconductrice (5) contient de l'Ag et un élément supprimant la diffusion de l'Ag.

12. Élément électroluminescent à semiconducteur selon la revendication 1, dans lequel la pluralité des électrodes du côté de la première couche semiconductrice (13) contient une partie principale disposée dans une matrice.

13. Élément électroluminescent à semiconducteur selon la revendication 1, dans lequel la surface de la première couche semiconductrice (2) du côté opposé à la couche électroluminescente (3) a une structure en micro cône.

14. Dispositif électroluminescent à semiconducteur comprenant :
un substrat de support (21) ;
une couche de câblage (W) qui est disposée sur le substrat de support (21), qui comporte une couche métallique réfléchissante en tant que couche supérieure, et qui comporte une pluralité de parties ; et
une pluralité d'éléments électroluminescents semiconducteurs selon la revendication 1, disposés à cheval sur des parties adjacentes de la couche de câblage (W) ayant la pluralité de parties,
dans lequel l'électrode du côté de la première couche semiconductrice (13) et l'électrode du côté de la deuxième couche semiconductrice (5) sont connectées à la couche de câblage (W).

15. Dispositif électroluminescent à semiconducteur selon la revendication 14, comprenant en outre :
une couche de résine d'étanchéité (45) disposée couvrant la pluralité d'éléments électroluminescents à semiconducteur ; et
une poudre fluorescente mélangée dans la couche de résine d'étanchéité (45).

16. Dispositif électroluminescent à semiconducteur selon la revendication 14, dans lequel la pluralité d'éléments électroluminescents à semiconducteur est disposée dans une direction et la couche de câblage (W) connecte la pluralité d'éléments électroluminescents à semiconducteur en série.

17. Dispositif électroluminescent à semiconducteur selon la revendication 14, dans lequel les électrodes du côté de la première couche semiconductrice (13) et l'électrode du côté de la deuxième couche semiconductrice (5) ont des couches d'AuSn en tant que couches supérieures et la couche de câblage (W) comporte une couche d'AuSn.

18. Dispositif électroluminescent à semiconducteur selon la revendication 14, comprenant en outre :
des couches absorbant la lumière disposées de telle sorte qu'elles entourent des régions de liaison au-dessus de deux parties disposées au plus à l'extérieur parmi la pluralité de parties de la couche de câblage (W).

19. Dispositif électroluminescent à semiconducteur selon la revendication 18, comprenant en outre :
un boîtier pourvu d'un matériau de liaison disposé au bas d'une partie de logement et d'une paire de plots d'entrée d'alimentation sur des parties latérales, et des fils de liaison (43),
dans lequel le matériau de liaison fixe le substrat de support (21) et les fils de liaison (43) connectent les plots d'entrée d'alimentation et les régions de liaison.

20. Dispositif électroluminescent à semiconducteur selon la revendication 14, comprenant en outre un système optique (51) pour irradier des lumières émises par les éléments électroluminescents à semiconducteur vers une direction prédéterminée, construisant une structure d'éclairage embarquée.
